(19) Europäisches Patentamt

European Patent Office

Office européen des brevets

(11) **EP 1 050 956 A1**

(12) **EUROPEAN PATENT APPLICATION**
published in accordance with Art. 158(3) EPC

(43) Date of publication:
08.11.2000 Bulletin 2000/45

(51) Int. Cl.$^7$: **H03D 1/18**

(21) Application number: **99900638.0**

(86) International application number:
**PCT/JP99/00149**

(22) Date of filing: **19.01.1999**

(87) International publication number:
**WO 99/37019 (22.07.1999 Gazette 1999/29)**

(84) Designated Contracting States:
**DE FR GB IT**

(30) Priority: **20.01.1998 JP 2284798**

(71) Applicant: **T.I.F. Co., Ltd.**
**Tokyo 143-0023 (JP)**

(72) Inventor:
**MIYAGI, Hiroshi,**
**Itopia Tsunashima 204**
**Yokohama-shi, Kanagawa 223-0 (JP)**

(74) Representative:
**Murgatroyd, Susan Elizabeth et al**
**Baron & Warren**
**18 South End**
**Kensington**
**London W8 5BU (GB)**

(54) **DETECTOR CIRCUIT**

(57)    A detector circuit for detecting waves without distortion, which can easily be fabricated totally into a chip. The detector circuit has a circuit configuration similar to a current mirror circuit, in which FETs are connected together through a resistor between their gates, and an input AM-modulated wave signal is coupled to one end of the resistor. The FET is connected at its drain with a low-pass filter that provides a detected output. The FET is also connected at its drain with a resistor, the resistance value of which is 0.8 times that of a resistor connected with the drain of the FET so that an unbalanced condition may be created between the FETs. The resistors have relatively large values so that the FETs can operate in a saturated region. Thus, only the signal correlated with either the positive or negative envelope of the modulated signal is obtained from the low-pass filter.

FIG. 1

EP 1 050 956 A1

**Description**

BACKGROUND OF THE INVENTION

Field of the Invention

The present invention relates to a detector circuit for demodulating an AM-modulated wave signal.

Description of the Prior Art

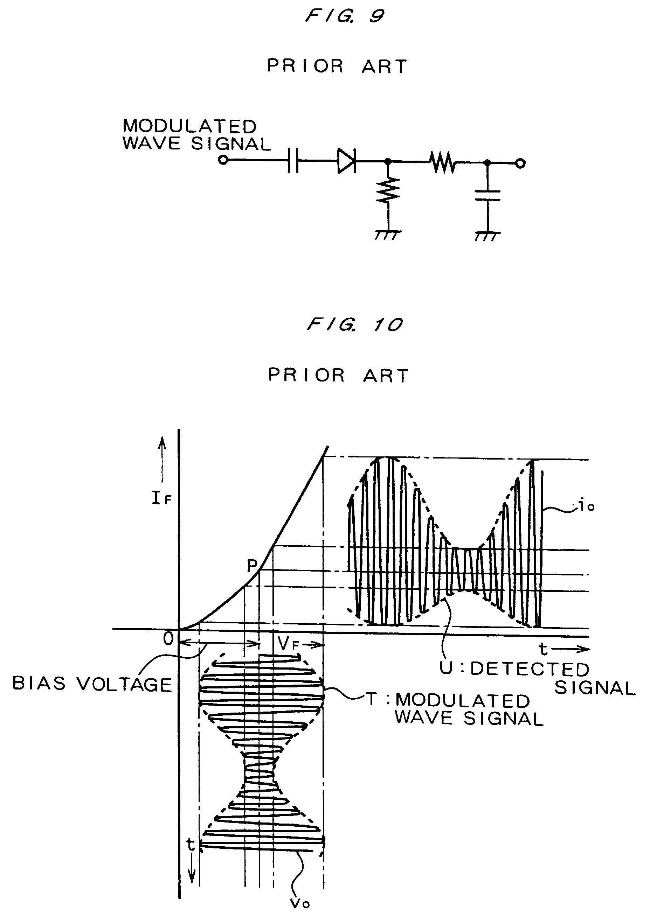

In case of demodulating an AM-modulated wave signal, a diode is often used. FIG. 9 is a circuit diagram showing one example of the detector circuit using a diode. The modulated wave signal is inputted to a diode via a DC-cut capacitor and rectified in a half-wave range. An output of the diode is inputted to a low-pass filter, so that a carrier component is removed and an original signal (hereinafter, referred to as "detected signal") is extracted.

FIG. 10 is a graph showing static characteristics of a diode, where an abscissa represents an anode-cathode voltage VF and an ordinate represents a current IF flowing between the anode and the cathode, respectively. As shown in FIG. 10, the diode has a square characteristic and exhibits a nonlinear characteristic in a range of small anode-cathode voltage VF. Accordingly, if any detection is performed by using this voltage range, the modulated wave signal represented by a curve T is forced to be greatly distorted in the waveform as represented by a curve U.

On the other hand, since a diode exhibits a linear characteristic in the range of large anode-cathode voltage VF, a circuit of reducing the distortion of a waveform by using this range for the detection has been proposed, but it involves a problem that the circuit is not only implicated but its characteristics are also unstable due to dispersions or the like of individual elements configuring the circuit.

Besides, in an attempt to make the whole detector circuit into a chip, it is desirable to form all elements configuring the detector circuit by a CMOS process in relation with the consumed power or the like, but there is a problem that a diode is difficult to form by the CMOS process also.

SUMMARY OF THE INVENTION

The invention has been created in consideration of these problems, while its object is to provide a detector circuit capable of performing a detection so as not to distort the waveform and being easily made into a chip as a whole circuit.

A detector circuit according to the present invention has a configuration basically similar to that of a current mirror circuit. A first resistor is connected between respective gate terminals of first and second transistors, to one end of which a modulated wave signal is inputted. Besides, connected to a drain terminal of the second transistor is a low-pass filter from which a signal demodulated of a modulated wave signal is outputted. By adjusting the resistance values of second and third resistors connected between the respective drain terminals of the first and second transistors and the a predetermined fixed power source terminal, a balance between the first transistor side and the second transistor side is intentionally collapsed so that only either one of the signals correlated to the positive or negative component of a modulated wave signal appears at the drain terminal of the second transistor. Thereby, from the low-pass filter, an envelope component of a modulated wave signal, i.e. an original signal prior to the modulation, is outputted.

A detector circuit according to the present invention has a configuration basically similar to that of a current mirror circuit. A first resistor is connected between respective base terminals of first and second NPN transistors, to one end of which a modulated wave signal is inputted. Besides, connected to a collector terminal of the second NPN transistor is a low-pass filter from which a signal demodulated of a modulated wave signal is outputted. By adjusting the resistance values of second and third resistors connected between the respective collector terminals of the first and second NPN transistors and the a predetermined fixed power source terminal, a balance between the first NPN transistor side and the second NPN transistor side is intentionally collapsed so that only either one of the signals correlated to the positive or negative component of a modulated wave signal appears at the collector terminal of the second NPN transistor. Thereby, from the low-pass filter, an envelope component of a modulated wave signal, i.e. an original signal prior to the modulation, is outputted.

A detector circuit according to the present invention has a configuration basically similar to that of a current mirror circuit. A first resistor is connected between respective base terminals of first and second PNP transistors, to one end of which a modulated wave signal is inputted. Besides, connected to an emitter terminal of the second PNP transistor is a low-pass filter from which a signal demodulated of a modulated wave signal is outputted. By adjusting the resistance values of second and third resistors connected between the respective emitter terminals of the first and second PNP transistors and the a predetermined fixed power source terminal, a balance between the first PNP transistor side and the second PNP transistor side is intentionally collapsed so that only either one of the signals correlated to the positive or negative component of a modulated wave signal appears at the emitter terminal of the second PNP transistor. Thereby, from the low-pass filter, an envelope component of a modulated wave signal, i.e. an original signal prior to the modulation, is outputted.

By setting the ratio of the resistance of a third resistor to that of the second one to a value not greater than 1 within a predetermined range, e.g. 0.8 in the above described three types of detector circuits, only a signal correlated to either the positive envelope component or the negative one of the modulated wave signal can be extracted without adding any other special circuit.

Besides, configuring a low-pass filter by connecting a fourth resistor and a capacitor in parallel with each other can simplify the circuit configuration and facilitates the circuit to be made into a chip as well.

BRIEF DESCRIPTION OF THE DRAWINGS

FIG. 1 is a circuit diagram of a detector circuit according to one embodiment applying the present invention;

FIG. 2 is an illustration of a principle of a current mirror circuit;

FIG. 3 is an illustration of an operation of a detector circuit where an operating point lies within a saturated region;

FIG. 4 is an equivalent circuit diagram showing an AC operation of the detector circuit of FIG. 1;

FIG. 5 is an illustration of an operation of the detector circuit where an operating point lies within an active region;

FIG. 6 is a graph showing a moving aspect of an operating point with variations in a ratio of resistance;

FIG. 7 is a circuit diagram of a detector circuit configured by using NPN transistors;

FIG. 8 is a circuit diagram of the detector circuit configured by using PNP transistors;

FIG. 9 is a circuit diagram showing one example of the detector circuit using a diode; and

FIG. 10 is a graph showing a static characteristic of the diode.

DESCRITPTION OF THE PREFERRED EMBODIMENTS

Referring to the drawings, a detector circuit according to the present invention will be specifically described below.

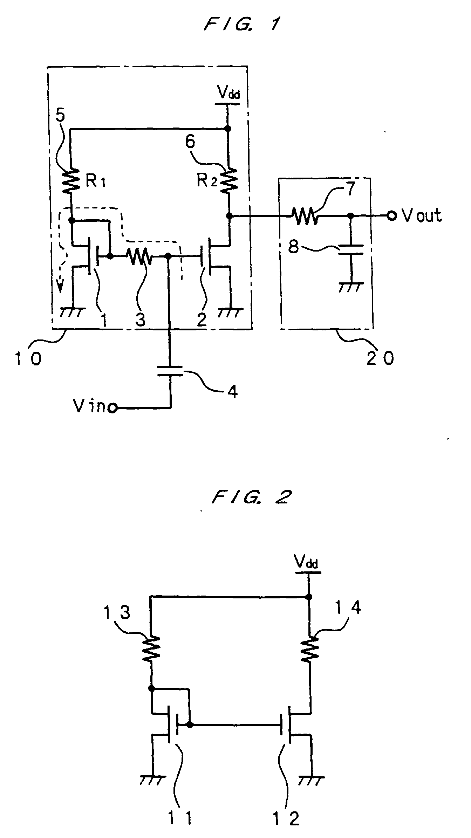

FIG. 1 is a circuit diagram of a detector circuit according to one embodiment applying the present invention. This detector circuit serves to demodulate an AM-modulated wave signal and is used in AM radio receivers or the like. Inside the detector circuit, two source-grounded MOS-type FETs 1 and 2 are provided, the respective terminals of which are connected via a resistor 3 to each other, and an AM-modulated wave signal is inputted to one end of the resistor 3 via a capacitor 4. Individual drain terminals of these FETs 1 and 2 are connected to a power source terminal Vdd via resistors 5 and 6 respectively. Besides, connected to a drain terminal of one FET 2 is a low-pass filter 20 composed of a resistor 7 and a capacitor 8, and a detected signal is outputted from this low-pass filter 20. After amplified, for example, at a low-frequency amplifier circuit (unillustrated), an output of the low-pass filter 20 is audio-outputted from a speaker (unillustrated).

The portion denoted by a symbol 10 in the detector circuit shown in FIG. 1 has a configuration seemingly similar to that of a current mirror circuit. FIG. 2 is an illustration of a principle of a current mirror circuit. As shown in FIG. 2, a current mirror circuit comprises two FETs 11 and 12 having their gate terminals directly coupled and is so configured as to short-circuit the gate terminal and the drain terminal of one FET 11 and moreover as to connect the drain terminals of individual FETs 11 and 12 to a power source terminal Vdd via resistors 13 and 14 respectively.

The FETs 11 and 12 shown in FIG. 2 are normally formed in adjacent region on a semiconductor wafer having same areas and become completely equal in electric characteristic. Since the gate and drain terminals of FET 11 is short-circuited, the drain-gate voltage VDG of the FET 11 becomes zero and the FET 11 operates in a saturated region. Accordingly, a drain current ID and a source current IS of the FET 11 become equal. Besides, since the gate terminals of individual FETs 11 and 12 are short-circuited, the gate voltages VG for both become equal and also the voltage across both ends of the resistor 13 and that across both ends of the resistor 14 becomes equal. Consequently, if these resistors 13 and 14 are made equal in resistance, the drain currents of individual FETs 11 and 12 become always constant and the current mirror circuit shown in FIG. 2 operates as a constant-current circuit.

On the other hand, in a portion denoted by the symbol 10 of FIG. 1, both resistors 5 and 6 are not made equal in resistance and a resistance value R1 of the resistor 5 is set to 0.8 time a resistance R2 of a resistor 6, for example. On setting the respective resistance values of two resistors 5 and 6 differently, a balance is lost between the FET 1 side and the FET 2 side and current flowing through the resistor 5 comes out of accordance with current flowing through the resistor 6. Incidentally, the manner of setting the resistance ratio between the two resistors 5 and 6 will be described below.

Besides, in the portion denoted by the symbol 10 of FIG. 1, a resistor 3 is connected between the respective gate terminals of two FETs 1 and 2. This resistor 3 is provided to prevent the modulated wave signal inputted through the input terminal Vin from flowing along the route of the dotted arrow of FIG. 1.

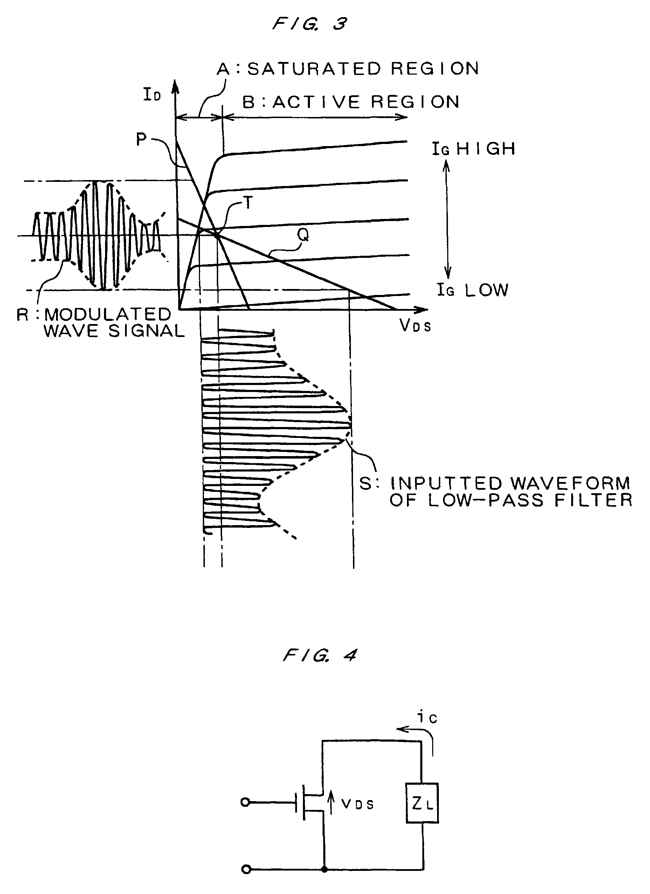

FIG. 3 is an illustration of an operation of a detector circuit where an operating point lies within a saturated region. FIG. 3 shows the operating characteristic of the FETs 1 and 2 for varied gate terminal voltages IG with the values of a drain-source voltage $V_{DS}$

and drain current ID laid off respectively as ordinates and abscissas. Hereinafter, a region A in which drain current $I_D$ drastically changes with varied drain-source voltages $V_{DS}$ and a region B in which a drain current ID does not change even for any variation in the drain-source voltage VDS will be referred to as saturated region and active region, respectively.

A DC operation of the detector circuit shown in FIG. 1 is expressed in terms of the following Equation (1):

$$Vdd = R2 \times ID + VDS \qquad (1).$$

On transforming Equation (1), Equation (2) is obtained:

$$ID = - (1/R2) VDS + Vdd/R2 \qquad (2).$$

This Equation (2) represents a DC load line, to which the straight line P of FIG. 3 corresponds.

On the other hand, an AC operation of the detector circuit shown in FIG. 1 becomes equivalent to the circuit shown in FIG. 4 if the capacitor 8 inside a low-pass filter 20 is assumed large enough to be regarded as being short-circuited from the AC standpoint. Thus, letting ZL be impedance of an AC load, a relation between output voltages vDS of the FET 2 and currents iC is obtained like Equation (3):

$$iC = - (1/ZL) vDS \qquad (3).$$

Equation (3) represents an AC load line, to which the straight line Q of FIG. 3 corresponds.

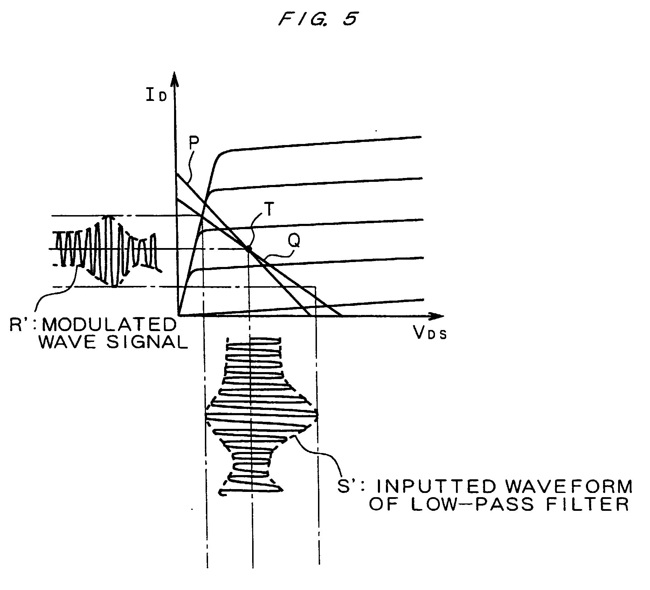

An intersecting point of a DC load line and an AC load line mentioned above is an operating point T and modulated wave signals are detected around this operating point T. If an operating point lies within an active region of the FETs 1 and 2 as shown in FIG. 5, a modulated wave signal (curve R' of FIG. 5) inputted to the detector circuit is to the low-pass filter 20 as it is kept equal in waveform without distorted (curve S' of FIG. 5).

In contrast, FIG. 3 shows a condition in which the operating point is set within the saturated region of the FETs 1 and 2. In this case, only the signal correlated to a negative envelope of a modulated wave signal R is extracted (curve S of FIG. 3) and the modulated wave signal can be detected at high precision by allowing this signal to pass through the low-pass filter 20.

Like this, operation of the FETs 1 and 2 within the saturated region is required for the detection of a modulated wave signal and accordingly the respective resistance values of individual resistors 5 and 6 are set above a predetermined value in a detector circuit according to this embodiment.

If a resistance value R1 of the resistor 5 is 10 kΩ with the power supply voltage Vdd, the current flowing through the resistor 5 and the ON resistance of the FET 1 set to 5V, 100 μA and 0.2V, for example, the terminal voltage of the resistor 5 amounts to 1V and 4V is imposed between the drain and the source of the FET 1, so that the FET 1 cannot be saturated. On the other hand, if a resistance value R1 of the resistor 5 is 49 kΩ, the drain-source voltage of the FET 1 amounts to 0.1V, so that the FET 1 surely operates within the saturated region. Thus, respective resistance values of the resistors 5 and 6 have to be set to a somewhat greater value in consideration of a value of current through the resistors 5 and 6 and a value of power supply voltage.

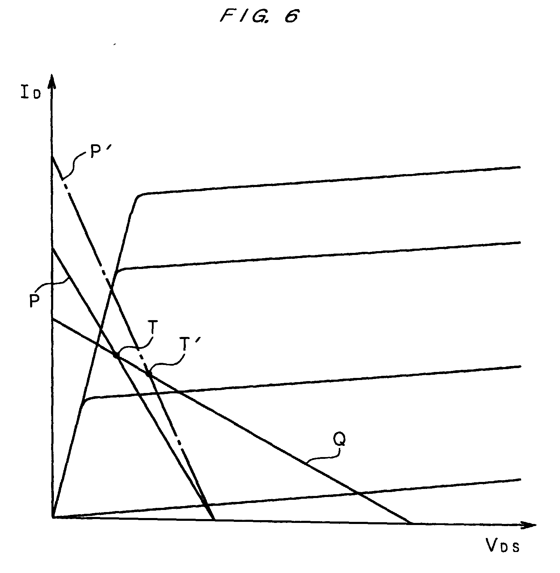

Besides, in a detector circuit according to this embodiment, the resistance R2 of the resistor 6 is set about 0.8 times the resistance R1 of the resistor 5. FIG. 6 shows a moving aspect of the operating point T with varied resistance ratios of the resistors 5 and 6. In FIG. 6, a solid line P and a one-dotted chain line P' denote DC load lines where a relation R1 = 0.8 × R2 is satisfied and where a relation R1 = R2 is satisfied, respectively. As illustrated, the operating point T for a resistance ratio of 0.8 (R1 = 0.8 × R2) between the resistors 5 and 6 is found to be present to the saturated region side of the operating point T' for R1 = R2.

By determining the respective resistance values of individual resistors 5 and 6 so that the FETs operate surely within the saturated region with the resistor ratio of the resistors 5 and 6 kept about 0.8 like this, only the positive or negative envelope component of an AM-modulated wave signal can be extracted as shown in FIG. 3.

Besides, since a drain current ID linearly varies with drain-source voltages VDS in a saturated region of the FETs 1 and 2, detecting a modulated wave signal with an operating point T set within the saturated region eliminates a distortion in waveform completely. Furthermore, a detector circuit according to this embodiment is easily made into a chip because of having a circuit configuration similar to that of a current mirror circuit frequently used in making an operator amplifier into a chip and making the detector circuit into a chip then can eliminate dispersions in electric characteristic of FETs 1 and 2 as well as resistors 5 and 6, thus enabling a highly precise detecting operation.

Incidentally, the resistance ratio of two resistors 5 and 6 does not always have to be 0.8 but is desirably determined at an appropriate value in relation with hFE of FETs 1 and 2, a voltage value of power supply voltage Vdd or the like.

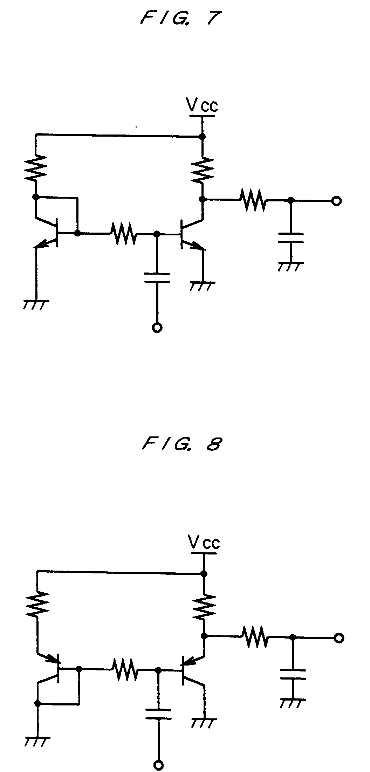

In FIG. 1, an example of configuring a detector circuit by using MOSFETs 1 and 2 was shown, but bipolar transistors can be used to configure a detector circuit also. For example, FIGS. 7 and 8 show one example of detector circuit configured by using NPN transistors and by using PNP transistors, respectively.

Besides, in the detector circuit shown in FIG. 1, one respective ends of two resistors 5 and 6 are connected to a common power supply terminal Vdd, but different voltages may be applied to one respective ends of two resistors 5 and 6. Furthermore, the source terminals of two FETs 1 and 2 may be connected to resistors or other elements instead of the ground.

INDUSTRIAL APPLICABILITY

As described above, according to the present invention, no diode is used and the saturated region of transistors is used to linearly perform a detection process, so that a modulated wave signal can be demodulated without any distortion. Besides, the presence of a circuit configuration similar to that of a current mirror circuit enables the whole detector circuit to be easily made into a chip and making the whole circuit into a chip can eliminate dispersions in electric characteristics of individual elements configuring the detector circuit. Furthermore, since there is no place to be adjusted than the resistance values of second and third resistors, dispersions can be eliminated among the products.

**Claims**

1. A detector circuit for demodulating an AM-modulated wave signal, comprising:

   a first transistor with a gate and a drain which are short-circuited;
   a second transistor to whose gate terminal said modulated wave signal is inputted;
   a first resistor connected between respective gate terminals of said first and second transistors;
   second and third resistors connected between respective drain terminals of said first and second transistors and a predetermined fixed power supply terminal; and
   a low-pass filter connected to the drain terminal of said second transistor for demodulating said modulated wave signal.

2. The detector circuit according to claim 1, wherein the resistance ratio of said second and third resistors is set so that a signal correlating with either one of a positive envelope or a negative envelope of said modulated wave signal is outputted from said low-pass filter.

3. The detector circuit according to claim 2, wherein the resistance values of said second and third resistors are adjusted so that said first and second transistors operate within a saturated region.

4. The detector circuit according to claim 2, wherein the ratio of the resistance value of said third resistor to the resistance value of said second resistor is set to a value within a predetermined extent not greater than 1.

5. The detector circuit according to claim 1, wherein said low-pass filter, composed of a fourth resistor and a capacitor connected in series, and outputs a demodulated signal from the connected point of said fourth resistor and said capacitor.

6. A detector circuit for demodulating an AM-modulated wave signal, comprising:

   a first NPN transistor with a base and a collector which are short-circuited;
   a second NPN transistor to whose base terminal said modulated wave signal is inputted;
   a first resistor connected between respective base terminals of said first and second NPN transistors;
   second and third resistors connected between respective collector terminals of said first and second NPN transistors and a predetermined fixed power supply terminal; and
   a low-pass filter connected to the collector terminal of said second NPN transistor for demodulating said modulated wave signal.

7. The detector circuit according to claim 6, wherein the resistance ratio of said second and third resistors is set so that a signal correlating with either one of a positive envelope or a negative envelope of said modulated wave signal is outputted from said low-pass filter.

8. The detector circuit according to claim 7, wherein the resistance values of said second and third resistors are adjusted so that said first and second NPN transistors operate within a saturated region.

9. The detector circuit according to claim 7, wherein the ratio of the resistance value of said third resistor to the resistance value of said second resistor is set to a value within a predetermined extent not greater than 1.

10. The detector circuit according to claim 6, wherein said low-pass filter, composed of a fourth resistor and a capacitor connected in series, and outputs a demodulated signal from the connected point of said fourth resistor and said capacitor.

11. A detector circuit for demodulating an AM-modulated wave signal, comprising:

    a first PNP transistor with a base and a collector which are short-circuited;
    a second PNP transistor to whose base terminal said modulated wave signal is inputted;
    a first resistor connected between respective base terminals of said first and second PNP transistors;

second and third resistors connected between respective emitter terminals of said first and second PNP transistors and a predetermined fixed power supply terminal; and

a low-pass filter connected to the emitter terminal of said second PNP transistor for demodulating said modulated wave signal.

12. The detector circuit according to claim 11, wherein the resistance ratio of said second and third resistors is set so that a signal correlating with either one of a positive envelope or a negative envelope of said modulated wave signal is outputted from said low-pass filter.

13. The detector circuit according to claim 12, wherein the resistance values of said second and third resistors are adjusted so that said first and second PNP transistors operate within a saturated region.

14. The detector circuit according to claim 12, wherein the ratio of the resistance value of said third resistor to the resistance value of said second resistor is set to a value within a predetermined extent not greater than 1.

15. The detector circuit according to claim 11, wherein said low-pass filter, composed of a fourth resistor and a capacitor connected in series, and outputs a demodulated signal from the connected point of said fourth resistor and said capacitor.

FIG. 1

FIG. 2

*FIG. 3*

A : SATURATED REGION
B : ACTIVE REGION

$I_D$

P

$I_G$ HIGH

T

Q

$I_G$ LOW

$V_{DS}$

R : MODULATED
WAVE SIGNAL

S : INPUTTED WAVEFORM
OF LOW-PASS FILTER

*FIG. 4*

ic

$V_{DS}$

$Z_L$

FIG. 5

$I_D$

P

T

Q

$V_{DS}$

R': MODULATED
WAVE SIGNAL

S': INPUTTED WAVEFORM
OF LOW-PASS FILTER

FIG. 6

FIG. 7

Vcc

FIG. 8

Vcc

## F I G. 9

## P R I O R   A R T

MODULATED
WAVE SIGNAL

## F I G. 10

## P R I O R   A R T

IF

P

0

VF

BIAS VOLTAGE

io

t

U : DETECTED
SIGNAL

T : MODULATED
WAVE SIGNAL

t

Vo

# INTERNATIONAL SEARCH REPORT

| | |
|---|---|
| International application No. | |
| PCT/JP99/00149 | |

**A. CLASSIFICATION OF SUBJECT MATTER**
Int.Cl⁶ H03D1/18

According to International Patent Classification (IPC) or to both national classification and IPC

**B. FIELDS SEARCHED**

Minimum documentation searched (classification system followed by classification symbols)
Int.Cl⁶ H03D1/00-1/28

Documentation searched other than minimum documentation to the extent that such documents are included in the fields searched

| Jitsuyo Shinan Koho | 1926-1996 | Toroku Jitsuyo Shinan Koho | 1994-1999 |
|---|---|---|---|
| Kokai Jitsuyo Shinan Koho | 1971-1999 | Jitsuyo Shinan Toroku Koho | 1996-1999 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP, 63-151109, A (NEC Corp.),<br>23 June, 1988 (23. 06. 88) (Family: none) | 1-5 |
| A | JP, 01-233982, A (Sony Corp.),<br>19 September, 1989 (19. 09. 19) (Family: none) | 6-10 |
| A | JP, 58-220506, A (Mitsubishi Electric Corp.),<br>22 December, 1983 (22. 12. 83) (Family: none) | 11-15 |
| A | JP, 61-164304, A (Matsushita Electric Industrial<br>Co., Ltd.),<br>25 July, 1986 (25. 07. 86) (Family: none) | 1-15 |
| A | JP, 61-237503, A (NEC IC Miconsystem K.K.),<br>22 October, 1986 (22. 10. 86) (Family: none) | 1-15 |
| A | JP, 62-163766, U (Pioneer Electronic Corp.),<br>17 October, 1987 (17. 10. 87) (Family: none) | 1-15 |
| A | JP, 04-170807, A (NEC Corp.),<br>18 June, 1992 (18. 06. 18) (Family: none) | |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | |
| "O" document referring to an oral disclosure, use, exhibition or other means | "Y" document of particular relevance; the claimed invention cannot be considered to involve an inventive step when the document is combined with one or more other such documents, such combination being obvious to a person skilled in the art |
| "P" document published prior to the international filing date but later than the priority date claimed | "&" document member of the same patent family |

| Date of the actual completion of the international search | Date of mailing of the international search report |
|---|---|
| 12 April, 1999 (12. 04. 99) | 27 April, 1999 (27. 04. 99) |

| Name and mailing address of the ISA/ | Authorized officer |
|---|---|
| Japanese Patent Office | |
| Facsimile No. | Telephone No. |

Form PCT/ISA/210 (second sheet) (July 1992)